# EUROPEAN PATENT SPECIFICATION

(11) **EP 3 830 590 B1**
(45) Date of publication and mention of the grant of the patent: **06.09.2023**
(21) Application number: 19765804.0
(22) Date of filing: 25.07.2019
(51) Int. Cl.: G01R 31/28, G01R 1/04

(54) **BUILT-IN MACHINERY TO CARRY OUT TEMPERATURE- DEPENDENT TESTS ON ELECTRONIC COMPONENTS SUCH AS CHIPS**
EINGEBAUTE MASCHINE ZUR DURCHFÜHRUNG VON TEMPERATURABHÄNGIGEN TESTS AN ELEKTRONISCHEN BAUELEMENTEN WIE CHIPS
MACHINERIE INTÉGRÉE POUR EFFECTUER DES ESSAIS DÉPENDANT DE LA TEMPÉRATURE SUR DES COMPOSANTS ÉLECTRONIQUES TELS QUE DES PUCES

(30) Priority: 30.07.2018 IT 201800007609
(43) Date of publication of application: 09.06.2021
(73) Proprietor: Microtest S.p.A., 56010 Vicopisano (IT)
(72) Inventor: AMELIO, Giuseppe, 55100 Lucca (IT)
(74) Representative: Emmi, Mario
(86) International application number: PCT/IB2019/056358
(87) International publication number: WO 2020/026092

(56) References cited:
- WO-A1-2009/118855
- JP-A- H11 271 389
- US-A- 5 220 277
- US-A1- 2004 077 200

## Description

### Technical field

The present invention relates to the technical field of machineries for carrying out temperature-dependent tests on electronic components in general, such as chips.

In particular, the invention relates to an innovative built-in machinery capable of enabling to carry out a temperature-dependent test on electronic components such as chips, printed circuit boards etc. remarkably saving energy and resulting in a particularly functional and simple machinery.

### Brief outline of the prior art

It is known that all electronic components such as chips, printed circuit boards, sensors, etc. must be electronically tested in order to check the correct working thereof.

Depending on the operation that the electronic component must perform, a suitable test must be provided which simulates a normal operating condition in order to check the correct working thereof.

The component under test is generally indicated with the English acronym DUT, "Device Under Test".

Tests are often carried out at predetermined temperatures, that is temperatures which may vary for example from -50°C to 180°C.

Depending on the electronic component and the device in which it will be installed, it might consequently be subject to extreme thermal operating conditions and, for this reason, it is necessary to test it in these conditions.

At the current state of the art, temperature-dependent tests require the use of testing machineries having a testing chamber where components are moved through mechanical arms and within which is arranged the device under test. The whole machinery is insulated from the external environment to be brought to the extreme thermal testing temperatures.

This kind of solution proved to be particularly complex for various reasons.

First of all, since the whole machinery is brought to testing temperature, all the mechanical and electronic parts constituting the machinery itself must be engineered to resist high rises/falls in temperature. This fact not only complicates remarkably the planning and production thereof, but also increases the costs of production and maintenance thereof.

In particular, if handling robotic arms are provided, they may be operating in an environment in which extreme temperature variations occurs, causing them high mechanical stress conditions.

Moreover, the environment to "heat" or "cool" is wide, since it basically surrounds the whole machinery and this requires more powerful and therefore more expensive air conditioning systems.

### Summary of the invention

Therefore, the aim of the present invention is to provide a testing machinery and relative testing method, which resolves said technical disadvantages.

In particular, the aim of the present invention is to provide an innovative machinery capable of carrying out temperature-dependent tests on electronic components, such as electronic chips, so as to enable a remarkable decrease in consumptions and so that this solution maintains at the most the componentry of the machinery itself.

These and other aims are therefore achieved with the present machinery to test, at a predetermined controlled temperature (**T**), one or more electronic components (**DUT**), according to claim 1.

This machinery (1) comprises:
- A surface (4);
- At least one test recess (25) obtained, for example dug, in a part of said surface (4) and in which the component under test can be arranged;
- Means (27, 28a, 28b, 200) for generating a predetermined thermal condition within said test recess (25) ;
- Said test recess (25) being configured for being substantially thermally insulated from the surrounding environment.

In this manner, all the said technical drawbacks are solved.

In particular, the temperature-dependent area is limited to the test recess only, which is thermally insulated from the rest of the machinery and from the rest of the surface 4 where it is obtained. In this manner, all the components of the machinery are protected from sudden temperature changes, thus being better preserved and then more long-lasting.

Therefore, the robotic arms of the machinery can operate outside the recess for the test 25 thus being preserved from sudden temperature changes.

Advantageously, a pre-conditioning recess (20) can be obtained into said surface (4) configured for keeping a predetermined temperature condition suitable for conditioning the components under test.

More particularly, advantageously, said recess for the test (25) can be obtained within the said pre-conditioning recess (20), for example at the base of the pre-conditioning recess (20).

In this manner, a pre-conditioning place is created, where to arrange all the components under test and then to move them one by one to the testing area obtained within the pre-conditioning recess itself.

Advantageously, said means for generating a predetermined temperature condition within the test recess (25) comprise at least one duct (27) arranged within the wall (30, 31) delimiting this recess for the test and suitable for enabling the circulation of a fluid at a predetermined temperature.

In this manner, the recess is readily brought to temperature.

Advantageously, a device (200) can be provided suitable for heating and/or cooling said fluid at the required temperature and piping it along said duct, preferably a liquid.

Advantageously, said means for generating a predetermined temperature condition within the recess for the test (25) comprise, in addition or alternative to the above solution, a gas flow (f2), preferably air, at a predetermined temperature and injected within said chamber by means of one or more injecting nozzles (29a, 29b) protruding from the walls delimiting the test recess (25).

Advantageously, said test recess (25) is made of a thermally insulating material.

Advantageously, the test recess is open on top.

In particular, advantageously, said test recess (25) is delimited by lateral walls, by an upper opening, through which the component under test can be inserted into it and by a base equipped with an arrangement place (26) on which the component under test can be arranged.

Advantageously, the machinery (1) further comprises a housing (11) for a testing device (100), said housing being arranged in such a way that, as soon as said testing device (100) is housed within said housing (11), a part thereof (101) provided with electric contacts for carrying out the test is arranged at said arrangement place (26).

In this manner, by arranging the DUT in the place 26, it is in electric contact with the ATE arranged below.

Advantageously, said test recess (25) is open on top for enabling the insertion of the component under test and a barrier element is comprised adapted to prevent and/or reduce the thermal dispersion through said upper opening.

The barrier element is obviously arranged above the component under test so as to close the opening delimiting a test volume which contains the component under test.

The publication WO2009/118855 is known which however does not describe a barrier element arranged above the component under test and therefore, according to this solution, a remarkable thermal leakage occurs upwards.

In a possible solution, advantageously, this barrier element can be in the form of a laminar gaseous flow (f1), preferably air.

It can be advantageously at a predetermined temperature, for example room temperature.

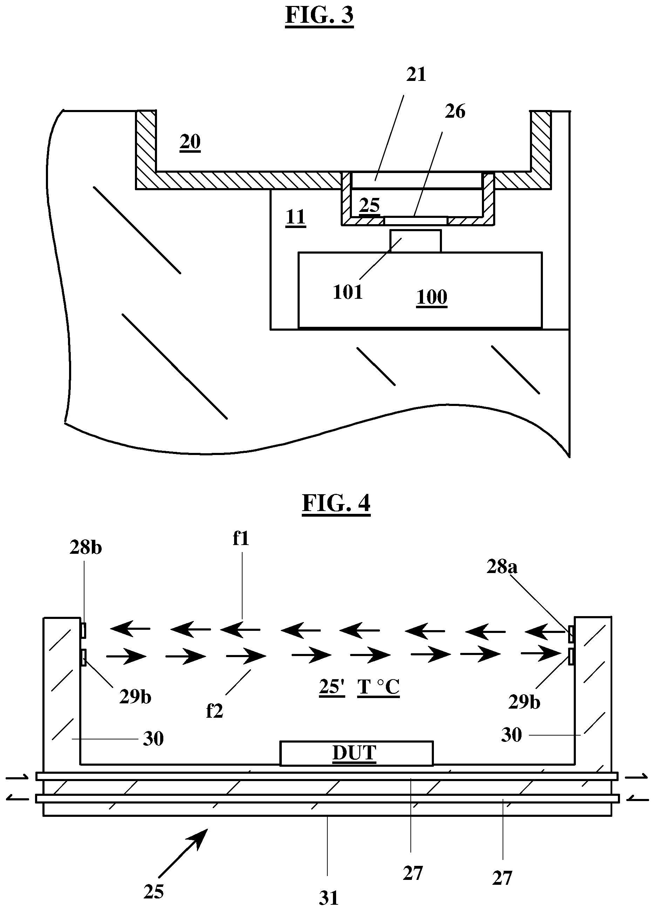

Therefore, the laminar gaseous flow f1 is arranged above the component under test thus creating this barrier element. Figure 4 depicts schematically the laminar flow f1 arranged for closing the upper opening above the component under test.

The laminar flow, as depicted in figure 4 and as well known in the art, is in form of a thin plane (for example, with a thickness under 1 mm) and formed by parallel planes of flows parallelly sliding among each other, unlike a turbulent flow in which fluids have vortical motion and then they radiate in irregular manner in the whole space.

The said laminar gaseous flow is advantageously generated through suitable nozzles (20a, 28b) which expel the flow so as to generate said barrier element and obviously with these nozzles arranged above the component under test, so that, as described above, the laminar gaseous flow is above the component under test thus creating a closing stopper.

In the known publication WO2009/118855 the discussed flow is not laminar and therefore does not form a barrier arranged above the component under test. Moreover, it is injected below and at the base of the component under test, therefore with a diametrically opposed solution with respect to the solution of the present invention.

Alternatively, a real lid can be used, preferably sliding, fold-out or a combination of both the lid and the laminar flow.

Advantageously, handling means (5) are arranged on said surface (4), for example at least one robotic arm (5) for moving the electronic components under test and/or a storage area (7) for the pieces under test, said movement means and/or said storage area being arranged outside the recess for the test (25).

Advantageously, a cover (3) of removable type can be provided, suitable for covering said surface (4).

It is also described here a method for carrying out a temperature-dependent test on one or more electronic components under test, the method comprising the following steps:
- Arrangement of at least one test recess (25) obtained, preferably dug, in a part of a surface (4) and within which the component under test can be arranged;
- Arrangement of means (27, 28a, 28b, 200) for generating a predetermined thermal condition in said test recess (25) and with said test recess (25) configured for being thermally insulated from the surrounding environment;
- The method providing the generation of a predetermined thermal condition exclusively within said recess and the arrangement of the component under test within the recess.

Advantageously, handling means (5) are provided suitable for handling said electronic components under test from a storage area (7, 7') to said recess (25) and vice versa.

Advantageously, these movement means are arranged outside the recess (25);
A particularly preferred and advantageous embodiment of the present invention is that providing a barrier to the thermal leakage through the upper opening, for example through a laminar flow arranged to close the opening above the component under test.

Therefore, the following embodiment is held to be advantageous:
A machinery (1) for testing one or more electronic components (**DUT**) at a predetermined controlled temperature (**T**), the machinery comprising:
- A surface (4);
- At least one test recess (25) obtained in a part of said surface (4) and into which the component under test can be arranged;
- Means (27, 28a, 28b, 200) for generating a predetermined thermal condition within said test recess (25) ;
- Said test recess (25) being thermally insulated from the surrounding environment;
- And wherein said recess is open above for enabling the insertion of the component under test and wherein a barrier element is comprised suitable for preventing and/or reducing the thermal dispersion through said upper opening and being arrangeable so as to be positioned above the component under test.

In this manner, the thermal leakage is limited and the place for the test is insulated from the rest of the machinery.

In a particularly advantageous embodiment, said barrier element is in form of a laminar gaseous flow (f1) at a predetermined temperature which is arranged above the electronic component to be tested.

In this manner, by activating the laminar flow, a stopper strongly limiting the leakage is generated through a simple solution which does not interrupt the operativeness, since the robotic arm can pass through the flow while operating the placement/removal of the piece without necessarily interrupting the flow.

The laminar gaseous flow can be activated/deactivated thus creating a stopper which can be passed through by the mechanical arms when they operate the arrangement and the removal of the pieces under test.

This flow is generated through suitable nozzles arranged at suitable height in the lateral walls.

Advantageously, it is also described here a method for carrying out a temperature-dependent test on one or more electronic components under test, the method comprising the following steps:
- Arrangement of at least one test recess (25) obtained in a part of a surface (4) and in which can be arranged the component under test;
- Arrangement of means (27, 28a, 28b, 200) for generating a predetermined thermal condition inside said test recess (25) and with said test recess (25) thermally insulated from the surrounding space;
- The method providing:
- The arrangement of the component under test within the recess and the generation of a predetermined thermal condition within said recess and wherein it is further provided the phase of arrangement of a barrier element arranged above the component under test and which closes above the opening of the recess for the test.

Advantageously, said arrangement of the barrier element comprises the generation of a laminar gaseous flow arranged above the component under test so as to form a barrier element which shuts above the chamber for the test (25) thus thermally insulating it.

### Brief description of the drawings

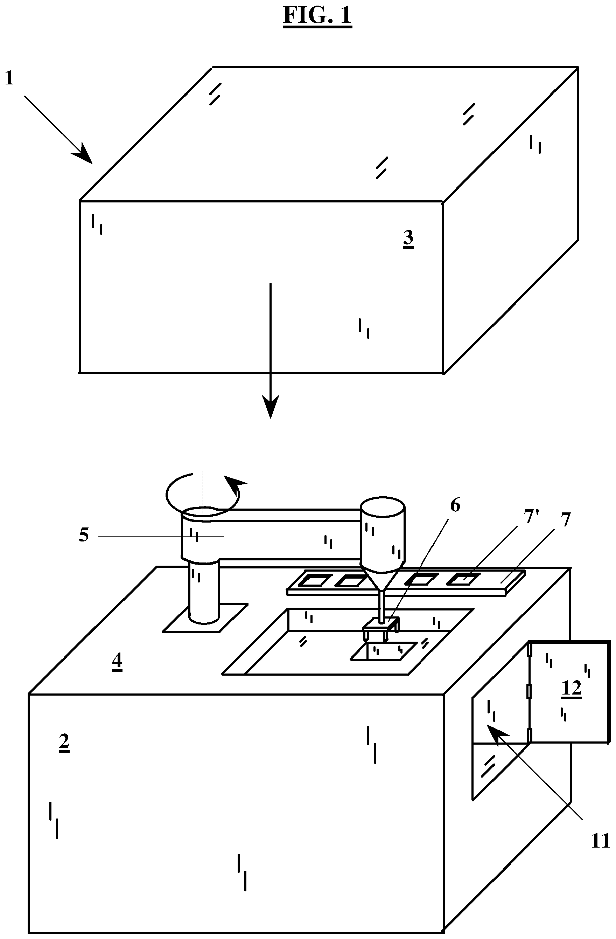

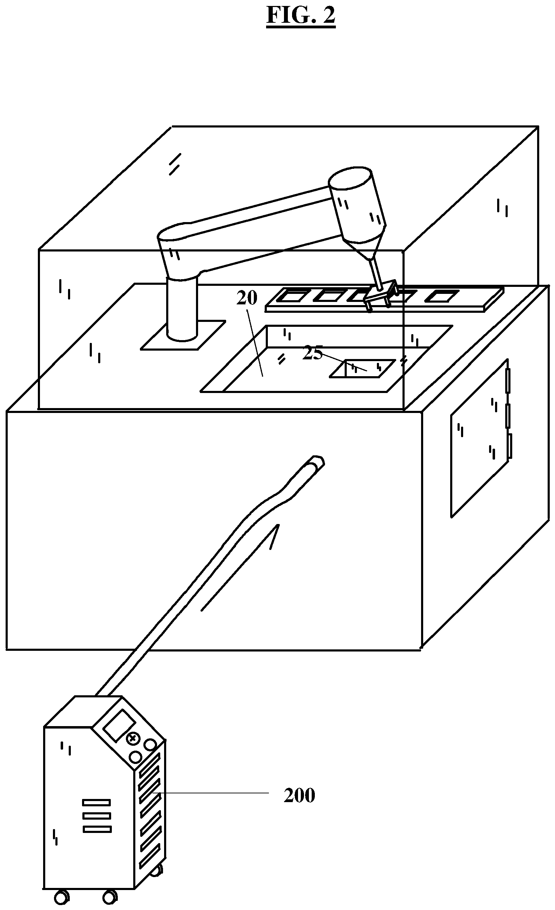

Additional features and advantages according to the invention will become apparent from the following description of preferred embodiments thereof, given only by way of non-limiting example, with reference to the attached drawings, wherein:
- Both figure 1 and figure 2 depict in axonometric view a schematization of the machinery for temperature-dependent tests according to the invention;
- Figure 3 depicts, in a broken-out section view, the area of the machinery in which the temperature-dependent test is carried out;
- Figure 4 depicts, in a section, the single cell in which the temperature-dependent test occurs and the components which cooperates with it.

### Description of some preferred embodiments

Both figure 1 and figure 2 depict in axonometric view a schematization of the machinery for carrying out predetermined temperature-dependent tests on electronic components, according to the invention.

The machinery is preferably built-in, as it comprises all the components for the test, including handling systems to handle the components under test.

The machinery, according to figure 1 and figure 2, comprises a bedplate 2 which forms a working plane 4 onto which one or more robotic arms 5 can be installed. To simplify, figure 1 and figure 2 depict an arm only but, obviously, the machinery can include even two or any number of arms.

The robotic arm works for moving the component under test from a point to another point within the working plane 4.

Any known robotic arm could be used and it is not the specific subject of the present invention.

By way of an example only and therefore in a not limiting way, figure 1 depicts a robotic arm 5 rotatable around an axis having a tool 6 (for example a sort of mechanical pliers or sucker system) which works for collecting and releasing components under test. This tool 6 can be slidingly mounted, so as to lower or raise it.

Other types of robotic arms with different kinematic motions can obviously be used.

As described above, the robotic arm and the equipment thereof for collecting and releasing objects are well known over the state of the art and they are not the specific subject of the present invention.

Always with reference to figure 1, a storage place 7 for components under test is provided on the working plane 4.

The storage place 7 can provide a series of recesses 7' in which, the component to be subjected to the temperature-dependent test is arranged in each of them, waiting to be tested, as explained thereinafter.

Then a cover 3 is provided which can be removable, for example made of transparent material such as plastic or similar materials.

Figure 1 depicts this cover 3 separated from the rest of the machinery while figure 2 depicts the cover 3 applied so as to insulate the testing environment in order to avoid contaminations.

Obviously, the cover is preferably transparent so as to enable operators to inspect the whole area relative to the working plane 4 and visually supervise the course of the test.

According to the invention, the working plane 4 provides a first tank 20 obtained in said working plane and a second tank 25 is present on the base thereof, as described thereinafter.

The first tank 20 delimits a place for thermally conditioning the components under test while the second tank 25 is the tank where the test on the component occurs effectively at the testing temperature.

In this manner, unlike prior art and as described thereinafter, the whole volume of the machinery delimited by the cover 3 and by the surface 4 remains at room temperature while the extreme test conditions are created and kept within the tanks 20 and 25 only.

Therefore, it is evident that, according to this solution, a remarkable energy saving is obtained by simplifying further the whole machinery.

In fact, the robotic arm 5 operates within an environment at an ordinary temperature of the laboratory and then it is not subjected to thermal shocks.

Moreover, the test volume is extremely reduced with respect to traditional machineries and then it implies a remarkable energy saving.

Therefore, by describing the invention in greater detail, always figure 1 depicts that a housing 11 is obtained in the bedplate 2, for example openable and closable through a suitable wicket 12.

The housing 11 serves for inserting and removing the device which is generally in use to test the electronic component, while, as said, the tank 20 and the tank 25 are the environment in which the prearranged temperature conditions are created.

The device which is generally used for tests is well known in itself and it is not the subject of the invention. It is known with the acronym ATE, *"Automatic Test Equipment".*

It is schematized in figure 3 with the number 100 and it is provided with a cradle 101 on which the component under test is arranged and it is fitted with electronic contacts to send signals for the test. Therefore, through the cradle, the ATE generates all the signals for the test.

When the ATE is inserted into the housing 11, the cradle 101 is arranged exactly below the tank 25 so that the robotic arm can position the electronic component under test, for example a board, above the cradle and with the electronic component under test which faces entirely within the tank 25.

Therefore, for this purpose, the tank 25 is fitted with a passage opening on the base thereof, i.e. the opening 26 of figure 3, which enables the cradle 101 to position itself for closing it.

Anyway, the opening 26 could be equivalently be closed by an electrically conductive component which transmits the signal from the underlying ATE to the component under test.

Obviously, an electric communication occurs in both cases.

Therefore, the operator can readily insert the ATE manually into the housing 11 when he must carry out a series of tests and then for example remove it at the end of the test.

Figure 4 schematically depicts the second tank for the test 25 according to the invention and represented, only for descriptive purposes, in isolated way from the plane 4 and from the first tank 20.

This tank 25, as clearly inferable from figure 4 and from figures 1 and 2, is delimited by lateral walls 30 and by a base 31 so as to delimit a test volume 25' which represents the volume brought to the required temperature for the test.

Obviously, the tank 25 is open above for the insertion of the component under test.

This tank is generally shaped with a rectangular or squared plan but any shape can be realized.

As depicted in figure 3 and as described above, the tank has preferably at the base 30 an opening 26 for enabling to apply the component under test on the underlying ATE.

Only for descriptive straightforwardness, figure 4 does not depict this opening which is present in figure 3 instead.

Figure 1 schematizes, in a not limiting way, a component (DUT) under test and arranged within the said chamber 25, in particular within the volume 25' of the chamber arranged at the required thermal condition, so as to be exposed to the temperature of the test.

The walls of the chamber are made of a thermally insulating material or they can be covered by insulating panels so as to be insulated better with respect to the external environment.

In this manner, the thermal condition created within the chamber is kept for enough time to carry out the test, thus reducing dissipations at a minimum.

Any insulating material useful for the purpose of thermal insulation can be used, without exceeding the scope of the present inventive concept.

Going further with the structural description of the invention, means for thermal regulation 27 are provided configured for enabling to create a predetermined temperature within the test volume 25'.

Preferably, the operative temperature obtainable within this volume 25' can vary from -60°C to approximately 180°C, and even more preferably from -50°C to 175°C.

It is immediately evident that the operating temperature range for carrying out the test is particularly wide and with particularly extreme peaks. Therefore, it is evident that the present solution enables the whole machine to be preserved enormously, since other components of the same machine, such as the robotic arm and electronic components are not forced to stand up to temperatures that can easily exceed one hundred degrees or fall far below zero degrees.

In the preferred embodiment of the invention, these means of thermal regulation 27 are in the form of a circulation system for a fluid, preferably a liquid.

In particular, as shown schematically in figure 2, a suitable device 200 can be provided which is able to heat or cool the fluid, preferably a liquid, used to create the temperature for the test. The device 200 heats or cools the fluid and injects it into the pipe/s 27 which run inside the walls of the tank 25, preferably but not necessarily on the base 31.

As described above, depending on the tests to be carried out, operative conditions vary from -50°C to 180°C approximately.

Machineries suitable to heat and/or cool a fluid to the said temperature are known per se and available on the market and they are not the specific subject of the present invention.

In addition, the liquid used to be injected into the pipes 27 can be freely selected depending on the cases, so that it is for example equipped with additives or with intrinsic physical properties such as not to freeze up to -50°C or not to evaporate up to 180°C.

Always in the first preferred embodiment of the invention and as schematically depicted in figure 4, the volume 25' which is brought to the temperature for the test is closed above through a first laminar flow (f1) at room temperature, for example at temperatures of the order of 25°C.

In this manner, the laminar flow (a gas such as air) creates a stopper that insulates the internal volume 25', thus limiting thermal leakages through the opening above.

The flow must be preferably laminar, so as to form a sort of thin plane and must be preferably at room temperature (room temperatures mean temperatures fluctuating from 22 to 27 degrees, preferably 25 degrees) so as to obtain a greater insulating effect.

Figure 4 depicts also a second flow f2 arranged below the flow f1.

Even if it is depicted as laminar in figure 4, it is not necessarily laminar and it is an air flow which is brought to the same temperature of the fluid circulating in the pipes so as to create the required thermal condition within the volume 25' in faster and more efficient manner.

Therefore, this flow f2 is preferably turbulent and anyway directed in such a way as to spread into the environment of the recess delimited by the upper laminar flow and the walls.

The same device 200 of figure 2 can heat/cool the gas f2 or a separated device can be provided.

A said, the device 200 is connected to possible quick connections on the machinery for the test to inject the fluid into the pipes and/or generate the air flow f2.

Then figure 4 schematizes the nozzles (28a, 28b) which generate the laminar flow (**f1**) and the nozzles (29a, 29b) which generate the temperature-dependent air flow within the chamber 25 (in case, laminar as well).

The laminar flow is readily obtained through a suitable shape of the nozzle and a suitable pressure of the flow.

As inferable from figure 4, the nozzles of the laminar flow (28a, 28b) are obviously arranged at a predetermined height so that the laminar flow is at a certain height from the base, so as to be arranged above the component under test and acts as cover.

A control device in form of a switch or similar ones enables to control the activation and the deactivation of the laminar flow f1 depending on the needs.

In a possible embodiment of the invention, provided what has been described heretofore, it is possible to provide a real cover for shutting tight the upper opening.

Obviously, it can be of thermally insulating material too.

Moreover, it is preferably of foldaway type so as to slide between a closing position and an opening position with an automated sliding system.

In order to achieve a better insulating condition, the first laminar flow f1 can be maintained despite the presence of the cover.

Alternatively, an embodiment with the cover only and without laminar flow f1 could be provided.

The flow f2 in combination with the pipes 27 where the liquid flows act together, in synergistic way, to reach better and earlier, the environmental condition within the chamber. Nevertheless, in all the embodiment described, the use of only one solution or the other solution could be provided.

Going further with the description of the invention, for all the embodiments described, it is preferable to provide also a conditioning tank depicted in figure 3 with number 20 (see also figure 1 and 2).

The conditioning tank, as inferable, is a chamber where the testing environment conditions or similar conditions are created.

Therefore, the conditioning tank 20 is as well dug in the surface 4 and it is shaped by lateral walls, a base in which the tank 25 is further dug and it is open above.

At the base of the conditioning tank, the tank 25 depicted in figure 4 is therefore dug.

The conditioning tank will be of insulating material as well and it is brought to the temperature for the test through a pipe system in which the fluid circulates exactly as the tank 25 and possibly taking advantage of the same device 200.

In this conditioning tank, the presence of the laminar flow at room temperature is not necessary (even if not excluded) for insulating the thermal leakage from the upper opening thereof.

Therefore, this tank 20 is not for testing but only for conditioning, hence the temperature value does not need to be precisely maintained as in the tank 25. The conditioning tank has a greater surface for enabling to put more components under test within it and each component is brought and tested one by one within the tank 25.

Through the presence of the preconditioning, tank the testing times are reduced in their whole, as many components which are arranged contextually in the preconditioning tank 20 reach the optimal temperature and when they are arranged in the tank for the test 25, they can be tested immediately without waiting further.

Substantially, therefore, through the present invention and in particular through the preconditioning chamber 20, a remarkable reduction of the conditioning time (soak time) occurs, since it is split between all the DUTs which are preconditioned.

Therefore, in use, the operation of the machinery of figure 1 and 2 is as follows.

On the storage place 7, within the dedicated recesses 7', the electronic components under test (the so-called DUT "Device under test") are positioned, which may be printed circuit boards or chips.

At this point, the ATE is arranged in the housing 11, taking care that the cradle 101 thereof faces toward the testing volume 25' within the tank 25 through the place 26 of the latter at the base.

Then the plane 4 is closed through the cover 3.

At this point, the robotic arm 5 (one robotic arm or more than one arm depending on the types of the built machinery), collects a certain number of components (DUT) in the storage place to position them within the recess 20 which represents the conditioning chamber (or pre-conditioning chamber, in other words).

When the cover has been applied, it is possible to create the testing conditions by activating the device or the devices 200 which serve for making the fluid circulate into the pipes and/or injecting the air flow (f2) at the required temperature.

In the same way, a similar environmental condition is created in the conditioning area 20 while the rest of the volume under the cover 3 is in fact at room temperature.

At this point, the robot 5, after waiting the necessary time to condition the components, collects the first component arranged in the tank 20 and puts it into the tank 25 in position on the cradle 101 so that the planned test is carried out for the necessary time. At the end of the test the arm removes the component and arranges it in the storage place and then it collects from the storage place a new component which replaces the former one in the tank 25.

By means of the barrier element, the tank for the test 25 is thermally insulated and no thermal leakage occurs.

Just as in form of a flow, other than the use of a cover, it is passed through the handling arm, with no need to open and close continuously as in the event of use of a physical barrier such as a surface of material.

The proceeding goes on until all the planned components are tested.

As explained in the description, it is inferable that, according to this solution, the volume of an environment brought to the testing temperature is limited to the pre-conditioning tank and the tank for the test only, while all the components of the machinery, including the robotized arms, are arranged outside at room temperature.

The conditioning chamber is important to preliminarily condition the components before the test and then to reduce the overall time of the operation. Nevertheless, it is not essential for the operation and for the scopes set by the present invention.

The preconditioning chamber as well could have a laminar flow f1 similar to that of chamber 25.

## Claims

1. A machinery (1) for testing one or more electronic components (DUT) at a predetermined controlled temperature (**T**), the machinery comprising:
- A surface (4);
- At least one test recess (25) obtained in a part of said surface (4) and into which the component under test can be arranged;
- Means (27, 28a, 28b, 200) for generating a predetermined thermal condition within said test recess (25) ;
- Said test recess (25) being thermally insulated from the surrounding environment;
- And wherein said test recess (25) has an upper opening for enabling the insertion of the component to be tested and a barrier element is further comprised suitable for preventing and/or reducing the thermal dispersion through said upper opening;
- **Characterized in that** the barrier element is in the form of a laminar gaseous flow (f1) forming a closure for the said upper opening, preferably said gas flow being air.

2. A machinery (1), according to claim 1, wherein a pre-conditioning recess (20) is obtained on said surface (4) configured for keeping a predetermined temperature condition suitable for conditioning the said electronic components under test.

3. A machinery, according to claim 2, wherein said test recess (25) is obtained at the base of the pre-conditioning recess (20).

4. A machinery, according to claim 1, wherein said means for generating a predetermined thermal condition within the test recess (25) comprise at least one duct (27) arranged within a wall (30, 31) delimiting said test recess and suitable for enabling the circulation of a fluid at a predetermined temperature.

5. A machinery, according to claim 4, comprising a device (200) suitable for heating and/or cooling said fluid at the required temperature and sending it along said duct, preferably said fluid being a liquid.

6. A machinery, according to one or more of the preceding claims, wherein said means for generating a predetermined thermal condition within the test recess (25) comprise a gas flow (**f2**) at a predetermined temperature and injected within said recess through one or more injecting nozzles (29a, 29b), preferably wherein said gas flow being air.

7. A machinery, according to one or more of the preceding claims, wherein said test recess (25) is delimited by lateral walls, by the said upper opening, through which the component under test can be inserted within it and by a base, preferably said base being equipped with an arrangement place (26) onto which the component under test can be arranged.

8. A machinery (1), according to one or more of the preceding claims, further comprising a housing (11) for a testing device (100), said housing being arranged so that, when said testing device (100) is housed within said housing (11), a part (101) of said testing device (100), provided with electric contacts for carrying out the test, is arranged at said arrangement place (26).

9. A machinery, according to claim 1, wherein said laminar gaseous flow (**f1**) is arranged above the component under test, preferably said laminar gaseous flow being air.

10. A machinery, according to claim 1 or 9, wherein said laminar gaseous flow is at room temperature, preferably said laminar gaseous flow being air.

11. A machinery, according to one or more of the preceding claims, wherein a plurality of nozzles (28a, 28b) are provided and arranged at a predetermined height so as to be positioned, in use, above the component under test and through which said laminar flow is generated.

12. A machinery, according to one or more of the preceding claims, wherein said laminar flow is selectively activatable/deactivatable.

13. A machinery, accordingly to any of the preceding claims, wherein the said laminar gas flow is a horizontal laminar gas flow.

14. A machinery (1), according to one or more of the preceding claims, wherein on said surface (4) handling means (5) are arranged for handling the electronic components under test and/or a storage place (7) for the items under test, said handling means and/or said storage place being outside the test recess (25).

15. A machinery, according to claim 14, wherein said handling means comprise at least one robotic arm (5).

16. A method for carrying out a temperature-dependent test on one or more electronic components to be tested, the method comprising the following steps:
- Arrangement of at least one test recess (25) obtained in a part of a surface (4) and into which it is arrangeable at least one electronic component to be tested, the test recess having an upper opening for the insertion of the said electronic component to be tested;
- Arrangement of means (27, 28a, 28b, 200) for generating a predetermined thermal condition inside said test recess (25) and with said test recess (25) thermally insulated from the surrounding space;
- The method providing the generation of a predetermined thermal condition within said recess and the arrangement of the component under test within the recess;
- And wherein the phase of arrangement of a barrier element to close said recess is provided for preventing and/or reduce the thermal dispersion through said upper opening, said barrier element being in the form of a laminar gas flow that closes said upper opening.

17. The method, according to claim 16, wherein the arrangement of handling means (5), suitable for moving said electronic components under test from a storage place to said recess and vice versa, is provided, said handling means being arranged outside the recess and arranging said component under test within said recess.

18. The method, according to claim 16 or 17, wherein said laminar gaseous flow is arranged above the component under test.

19. The method, accordingly to any of claims from 16 to 18, wherein the said laminar gas flow is generated through suitable nozzles (20a, 20b) arranged above the component under test so as the said laminar gas flow is positioned above the component under test.

20. A use of a machinery according to any of claims 1 to 15 for testing one or more electronic components (DUT) at a predetermined controlled temperature (T), wherein a laminar gas flow that, when generated, forms a closure for said upper opening for preventing and/or reducing the thermal dispersion through said upper opening.

## Patentansprüche

1. Maschinen (1) zum Testen eines oder mehrerer elektronischer Bauteile (DUT) bei einer vorbestimmten kontrollierten Temperatur (T), wobei die Maschinen umfassen:
- eine Oberfläche (4);
- mindestens eine Testausnehmung (25), die in einem Teil der Oberfläche (4) erhalten wird und in der das zu testende Bauteil angeordnet werden kann;
- Mittel (27, 28a, 28b, 200) zum Erzeugen einer vorbestimmten thermischen Bedingung innerhalb der Testausnehmung (25);
- wobei die Testausnehmung (25) von der Umgebung thermisch isoliert ist;
- und wobei die Testausnehmung (25) eine obere Öffnung aufweist, um das Einsetzen des zu testenden Bauteils zu ermöglichen, und ferner ein Barriereelement umfasst, das geeignet ist, die thermische Dispersion durch die obere Öffnung zu verhindern und/oder zu reduzieren;
- **dadurch gekennzeichnet, dass** das Barriereelement in Form eines laminaren Gasstroms (f1) vorliegt, der einen Verschluss für die obere Öffnung bildet, wobei der Gasstrom vorzugsweise aus Luft besteht.

2. Maschinen (1) nach Anspruch 1, wobei eine Vorkonditionierungsausnehmung (20) auf der Oberfläche (4) erhalten ist, die so konfiguriert ist, dass sie eine vorbestimmte Temperaturbedingung aufrechterhält, die für die Konditionierung der zu testenden elektronischen Bauteile geeignet ist.

3. Maschinen nach Anspruch 2, wobei die Testausnehmung (25) am Boden der Vorkonditionierungsausnehmung (20) erhalten wird.

4. Maschinen nach Anspruch 1, wobei die Mittel zum Erzeugen einer vorbestimmten thermischen Bedingung innerhalb der Testausnehmung (25) mindestens einen Kanal (27) umfassen, der innerhalb einer die Testausnehmung begrenzenden Wand (30, 31) angeordnet und geeignet ist, die Zirkulation eines Fluids mit einer vorbestimmten Temperatur zu ermöglichen.

5. Maschinen nach Anspruch 4, umfassend eine Vorrichtung (200), die geeignet ist, das Fluid auf die erforderliche Temperatur zu erwärmen und/oder zu kühlen und es entlang des Kanals zu leiten, wobei das Fluid vorzugsweise eine Flüssigkeit ist.

6. Maschinen nach einem oder mehreren der vorstehenden Ansprüche, wobei die Mittel zum Erzeugen einer vorbestimmten thermischen Bedingung innerhalb der Testausnehmung (25) einen Gasstrom (**f2**) mit einer vorbestimmten Temperatur umfassen und in die Ausnehmung durch eine oder mehrere Einspritzdüsen (29a, 29b) eingespritzt werden, wobei der Gasstrom vorzugsweise Luft ist.

7. Maschinen nach einem oder mehreren der vorstehenden Ansprüche, wobei die Testausnehmung (25) durch Seitenwände, durch die obere Öffnung, durch die das zu testende Bauteil in sie eingeführt werden kann, und durch einen Boden begrenzt ist, wobei der Boden vorzugsweise mit einem Anordnungsplatz (26) ausgestattet ist, auf dem das zu testende Bauteil angeordnet werden kann.

8. Maschinen (1) nach einem oder mehreren der vorstehenden Ansprüche, ferner umfassend ein Gehäuse (11) für eine Testvorrichtung (100), wobei das Gehäuse so angeordnet ist, dass, wenn die Testvorrichtung (100) in dem Gehäuse (11) untergebracht ist, ein Teil (101) der Testvorrichtung (100), der mit elektrischen Kontakten zur Durchführung des Tests versehen ist, an dem Anordnungsplatz (26) angeordnet ist.

9. Maschinen nach Anspruch 1, wobei der laminare Gasstrom (**f1**) über dem zu testenden Bauteil angeordnet ist, wobei der laminare Gasstrom vorzugsweise Luft ist.

10. Maschinen nach Anspruch 1 oder 9, wobei der laminare Gasstrom Raumtemperatur hat und der laminare Gasstrom vorzugsweise Luft ist.

11. Maschinen nach einem oder mehreren der vorstehenden Ansprüche, wobei eine Vielzahl von Düsen (28a, 28b) vorgesehen und in einer vorbestimmten Höhe angeordnet sind, so dass sie im Gebrauch über dem zu testenden Bauteil positioniert sind und durch die die laminare Strömung erzeugt wird.

12. Maschinen nach einem oder mehreren der vorstehenden Ansprüche, wobei die laminare Strömung selektiv aktivierbar/deaktivierbar ist.

13. Maschinen nach einem der vorstehenden Ansprüche, wobei der laminare Gasstrom ein horizontaler laminarer Gasstrom ist.

14. Maschinen (1) nach einem oder mehreren der vorstehenden Ansprüche, wobei auf der Oberfläche (4) Handhabungsmittel (5) zur Handhabung der zu testenden elektronischen Bauteile und/oder ein Aufbewahrungsort (7) für die zu testenden Gegenstände angeordnet sind, wobei sich die Handhabungsmittel und/oder der Aufbewahrungsort außerhalb der Testausnehmung (25) befinden.

15. Maschinen nach Anspruch 14, wobei die Handhabungsmittel mindestens einen Roboterarm (5) umfassen.

16. Verfahren zur Durchführung eines temperaturabhängigen Tests an einem oder mehreren zu testenden elektronischen Bauteilen, wobei das Verfahren die folgenden Schritte umfasst:
- Anordnen von mindestens einer Testausnehmung (25), die in einem Teil einer Oberfläche (4) erhalten wird und in der mindestens ein zu testendes elektronisches Bauteil angeordnet werden kann, wobei die Testausnehmung eine obere Öffnung zum Einführen des zu testenden elektronischen Bauteils aufweist;
- Anordnen von Mitteln (27, 28a, 28b, 200) zum Erzeugen einer vorbestimmten thermischen Bedingung innerhalb der Testausnehmung (25), wobei die Testausnehmung (25) von dem umgebenden Raum thermisch isoliert ist;
- wobei das Verfahren die Erzeugung einer vorbestimmten thermischen Bedingung innerhalb der Ausnehmung und das Anordnen des zu testenden Bauteils innerhalb der Ausnehmung vorsieht;
- und wobei die Phase des Anordnens eines Barriereelements zum Verschließen der Ausnehmung vorgesehen ist, um die thermische Dispersion durch die obere Öffnung zu verhindern und/oder zu verringern, wobei das Barriereelement in Form eines laminaren Gasstroms vorliegt, der die obere Öffnung verschließt.

17. Verfahren nach Anspruch 16, wobei das Anordnen von Handhabungsmitteln (5) vorgesehen ist, die geeignet sind, die zu testenden elektronischen Bauteile von einem Lagerplatz zu der Ausnehmung und umgekehrt zu bewegen, wobei die Handhabungsmittel außerhalb der Ausnehmung angeordnet sind, und das zu testende Bauteil innerhalb der Ausnehmung anzuordnen.

18. Verfahren nach Anspruch 16 oder 17, wobei der laminare Gasstrom über dem zu testenden Bauteil angeordnet ist.

19. Verfahren nach einem der Ansprüche 16 bis 18, wobei der laminare Gasstrom durch geeignete Düsen (20a, 20b) erzeugt wird, die oberhalb des zu testenden Bauteils angeordnet sind, so dass der laminare Gasstrom oberhalb des zu testenden Bauteils positioniert ist.

20. Verwendung von Maschinen nach einem der Ansprüche 1 bis 15 zum Testen eines oder mehrerer elektronischer Bauteile (DUT) bei einer vorbestimmten kontrollierten Temperatur (T), wobei ein laminarer Gasstrom, der, wenn er erzeugt wird, einen Verschluss für die obere Öffnung bildet, um die thermische Dispersion durch die obere Öffnung zu verhindern und/oder zu reduzieren.

## Revendications

1. Machinerie (1) pour tester un ou plusieurs composants électroniques (DUT) à une température contrôlée prédéterminée (T), la machinerie comprenant :
- Une surface (4) ;
- Au moins une cavité d'essai (25) obtenue dans une partie de ladite surface (4) et dans laquelle le composant à tester peut être placé ;
- Des moyens (27, 28a, 28b, 200) pour générer une condition thermique prédéterminée à l'intérieur de ladite cavité d'essai (25) ;
- Ladite cavité d'essai (25) étant isolée thermiquement du milieu environnant ;
- Et dans lequel ladite cavité d'essai (25) a une ouverture supérieure pour permettre l'insertion du composant à tester et un élément de barrière est également compris pour empêcher et/ou réduire la dispersion thermique à travers ladite ouverture supérieure ;
- **Caractérisée en ce que** l'élément de barrière se présente sous la forme d'un écoulement de gaz laminaire (f1) formant une fermeture pour ladite ouverture supérieure, de préférence ledit écoulement de gaz étant de l'air.

2. Machinerie (1) selon la revendication 1, dans laquelle une cavité de préconditionnement (20) est obtenue sur ladite surface (4) configurée pour maintenir une condition de température prédéterminée convenant au conditionnement desdits composants électroniques testés.

3. Machinerie selon la revendication 2, dans laquelle ladite cavité d'essai (25) est obtenue à la base de la cavité de préconditionnement (20).

4. Machinerie selon la revendication 1, dans laquelle lesdits moyens pour générer une condition thermique prédéterminée à l'intérieur de la cavité d'essai (25) comprennent au moins un conduit (27) disposé à l'intérieur d'une paroi (30, 31) délimitant ladite cavité d'essai et pouvant permettre la circulation d'un fluide à une température prédéterminée.

5. Machinerie selon la revendication 4, comprenant un dispositif (200) pouvant chauffer et/ou refroidir ledit fluide à la température requise et à l'envoyer le long dudit conduit, de préférence ledit fluide étant un liquide.

6. Machinerie selon l'une ou plusieurs des revendications précédentes, dans laquelle lesdits moyens pour générer une condition thermique prédéterminée dans la cavité d'essai (25) comprennent un écoulement de gaz (**f2**) à une température prédéterminée et injecté dans ladite cavité à travers une ou plusieurs buses d'injection (29a, 29b), de préférence dans laquelle ledit écoulement de gaz est de l'air.

7. Machinerie selon l'une ou plusieurs des revendications précédentes, dans laquelle ladite cavité d'essai (25) est délimitée par des parois latérales, par ladite ouverture supérieure, à travers laquelle le composant testé peut être inséré à l'intérieur et par une base, de préférence ladite base étant équipée d'un endroit d'agencement (26) sur lequel le composant testé peut être disposé.

8. Machinerie (1) selon l'une ou plusieurs des revendications précédentes, comprenant en outre un boîtier (11) pour un dispositif d'essai (100), ledit boîtier étant disposé de telle sorte que, lorsque ledit dispositif d'essai (100) est logé dans ledit boîtier (11), une partie (101) dudit dispositif d'essai (100), pourvue de contacts électriques pour effectuer l'essai, est disposée à l'endroit d'agencement (26).

9. Machinerie selon la revendication 1, dans laquelle l'écoulement de gaz laminaire (**f1**) est disposé au-dessus du composant testé, de préférence ledit écoulement de gaz laminaire étant de l'air.

10. Machinerie selon la revendication 1 ou 9, dans laquelle ledit écoulement de gaz laminaire est à température ambiante, de préférence ledit écoulement de gaz laminaire étant de l'air.

11. Machinerie selon l'une ou plusieurs des revendications précédentes, dans laquelle plusieurs buses (28a, 28b) sont prévues et disposées à une hauteur prédéterminée de manière à être positionnées, en cours d'utilisation, au-dessus du composant testé et à travers lesquelles ledit écoulement laminaire est généré.

12. Machinerie selon l'une ou plusieurs des revendications précédentes, dans laquelle ledit écoulement laminaire est sélectivement activable/désactivable.

13. Machinerie selon l'une quelconque des revendications précédentes, dans laquelle ledit écoulement de gaz laminaire est un écoulement de gaz laminaire horizontal.

14. Machinerie (1), selon l'une ou plusieurs des revendications précédentes, dans laquelle, sur ladite surface (4), des moyens de manutention (5) sont disposés pour manipuler les composants électroniques testés et/ou un lieu de stockage (7) pour les éléments testés, lesdits moyens de manutention et/ou ledit lieu de stockage se trouvant à l'extérieur de la cavité d'essai (25).

15. Machinerie selon la revendication 14, dans laquelle lesdits moyens de manutention comprennent au moins un bras robotisé (5).

16. Procédé pour effectuer un test en fonction de la température sur un ou plusieurs composants électroniques à tester, le procédé comprenant les étapes suivantes :
- Disposition d'au moins une cavité d'essai (25) obtenue dans une partie d'une surface (4) et dans laquelle peut être disposé au moins un composant électronique à tester, la cavité d'essai ayant une ouverture supérieure pour l'insertion dudit composant électronique à tester ;
- Disposition de moyens (27, 28a, 28b, 200) pour générer une condition thermique prédéterminée à l'intérieur de ladite cavité d'essai (25) et avec ladite cavité d'essai (25) thermiquement isolée de l'espace environnant ;
- Le procédé prévoit la génération d'une condition thermique prédéterminée à l'intérieur de ladite cavité et la disposition du composant testé à l'intérieur de la cavité ;
- Et dans lequel la phase de disposition d'un élément de barrière pour fermer ladite cavité est prévue pour empêcher et/ou réduire la dispersion thermique à travers ladite ouverture supérieure, ledit élément de barrière étant sous la forme d'un écoulement de gaz laminaire qui ferme ladite ouverture supérieure.

17. Procédé selon la revendication 16, dans lequel la disposition des moyens de manutention (5) sont prévus pour déplacer lesdits composants électroniques testés d'un lieu de stockage vers ladite cavité et vice versa, lesdits moyens de manutention étant disposés à l'extérieur de la cavité et disposant lesdits composants testés à l'intérieur de ladite cavité.

18. Procédé selon la revendication 16 ou 17, dans lequel ledit écoulement de gaz laminaire est disposé au-dessus du composant testé.

19. Procédé selon l'une quelconque des revendications 16 à 18, dans lequel ledit écoulement de gaz laminaire est généré par des buses appropriées (20a, 20b) disposées au-dessus du composant testé de manière à ce que ledit écoulement de gaz laminaire soit positionné au-dessus du composant testé.

20. Utilisation d'une machinerie selon l'une quelconque des revendications 1 à 15 pour tester un ou plusieurs composants électroniques (DUT) à une température contrôlée prédéterminée (T), dans laquelle un écoulement de gaz laminaire qui, lorsqu'il est généré, forme une fermeture pour ladite ouverture supérieure afin d'empêcher et/ou de réduire la dispersion thermique à travers ladite ouverture supérieure.
